# EUROPEAN PATENT APPLICATION

(11) **EP 3 089 199 A1**
(43) Date of publication of application: **02.11.2016**
(21) Application number: 14874449.3
(22) Date of filing: 25.12.2014
(51) Int. Cl.: H01L 21/20, H01L 21/02, H01L 21/205

(54) **SEMICONDUCTOR SUBSTRATE AND METHOD FOR MANUFACTURING SEMICONDUCTOR SUBSTRATE**

(30) Priority: 25.12.2013 JP 2013267721
(71) Applicant: Kabushiki Kaisha Toyota Jidoshokki, Kariya-shi, Aichi 448-8671 (JP); Suda, Jun, Otsu-shi, Shiga 520-0852 (JP)
(72) Inventor: SUDA Jun, Otsu-shi Shiga 520-0852 (JP); IMAOKA Ko, Kariya-shi Aichi 448-8671 (JP); UCHIDA Hidetsugu, Tokyo 101-0023 (JP)
(74) Representative: Winter, Brandl, Fürniss, Hübner, Röss, Kaiser, Polte - Partnerschaft mbB
(86) International application number: PCT/JP2014/084288
(87) International publication number: WO 2015/099028

(57) **Abstract**

A semiconductor substrate including plural types of semiconductor layers exposed at a surface thereof is provided. A semiconductor substrate includes: a supporting substrate; a single-crystal, first semiconductor layer disposed on a surface of the supporting substrate; a single-crystal, second semiconductor layer disposed on parts of a surface of the first semiconductor layer; and a single-crystal, third semiconductor layer disposed on those parts of the surface of the first semiconductor layer on which the second semiconductor layer is not disposed. The third semiconductor layer has a crystal orientation aligned with that of the first semiconductor layer and is made of the same material as the first semiconductor layer.

## Description

### TECHNICAL FIELD

This application claims priority to Japanese Patent Application No. 2013-267721 filed on December 25, 2013, the contents of which are hereby incorporated by reference into the present application. The art disclosed herein relates to a semiconductor substrate including plural types of semiconductor layers exposed at a surface thereof and a method for manufacturing such a semiconductor substrate.

### BACKGROUND ART

There is a case where a plurality of devices whose substrates are made of different materials or a plurality of devices whose substrates are made of semiconductor single-crystals having different plane directions are used in combination. In this case, the devices are fabricated in the form of semiconductor chips for each different material or for each different plane direction, and these semiconductor chips are mounted into one package. Further, a relevant art is disclosed in Japanese Unexamined Patent Application Publication No. JP-A-2010-199338.

### SUMMARY OF INVENTION

### TECHNICAL PROBLEM

Mounting a plurality of semiconductor chips into one package requires steps such as a step of separating the semiconductor chips from each other and a step of wire-bonding each of the semiconductor chips to the other.

### SOLUTION TO PROBLEM

The present specification discloses a semiconductor substrate. The semiconductor substrate includes: a supporting substrate; a single-crystal, first semiconductor layer disposed on a surface of the supporting substrate; a single-crystal, second semiconductor layer disposed on parts of a surface of the first semiconductor layer; and a single-crystal, third semiconductor layer disposed on those parts of the surface of the first semiconductor layer on which the second semiconductor layer is not disposed. The third semiconductor layer has a crystal orientation aligned with that of the first semiconductor layer and is made of the same material as the first semiconductor layer.

In the semiconductor substrate described above, a surface of the second semiconductor layer and a surface of the third semiconductor layer can be exposed at desired regions, respectively, of the semiconductor substrate. With this, for example, a combination of a device fabricated with the second semiconductor layer and a device fabricated with the third semiconductor layer can be manufactured in a region that is to be cut out as one semiconductor chip. Further, a wire between the device fabricated with the second semiconductor layer and the device fabricated with the third semiconductor layer can be fabricated by a semiconductor process for fabricating various devices. This makes it possible to eliminate the need for post-processing steps of fabricating, as separate semiconductor chips, the device fabricated with the second semiconductor layer and the device fabricated with the third semiconductor layer and mounting these semiconductor chips into one package. This in turn makes it possible to achieve simpler device structures and lower manufacturing costs. Further, by placing the third semiconductor layer on the surface of the first semiconductor layer, heights of the surface of the third semiconductor layer and the surface of the second semiconductor layer relative to each other can be adjusted.

### ADVANTAGEOUS EFFECTS OF INVENTION

The art disclosed herein makes it possible to provide a semiconductor substrate including plural types of semiconductor layers exposed at a surface thereof and a method for manufacturing such a semiconductor substrate.

### BRIEF DESCRIPTION OF DRAWINGS

FIG. 1 is a top view of a semiconductor substrate;
FIG. 2 is a cross-sectional view of the semiconductor substrate;
FIG. 3 is a flow chart (part 1) showing a process for manufacturing a semiconductor substrate;
FIG. 4 is a schematic view explaining the process for manufacturing a semiconductor substrate;
FIG. 5 is a schematic view explaining the process for manufacturing a semiconductor substrate;
FIG. 6 is a schematic view explaining the process for manufacturing a semiconductor substrate;
FIG. 7 is a partially-enlarged view of a region R1; and
FIG. 8 is a cross-sectional view of a semiconductor substrate.

### BEST MODE FOR CARRYING OUT THE INVENTION

Preferred aspects of embodiments disclosed herein will be listed. It should be noted that elements described below may technically be useful alone.
(Aspect 1) The semiconductor substrate may further include a single-crystal, fourth semiconductor layer disposed on a surface of the second semiconductor layer. The fourth semiconductor layer may have a crystal orientation aligned with that of the second semiconductor layer and be made of the same material as the second semiconductor layer. An interface between the third semiconductor layer and the fourth semiconductor layer may be in an amorphous state. This allows a surface of the third semiconductor layer and a surface of the fourth semiconductor layer to be exposed at desired regions, respectively, of the semiconductor substrate. Therefore, a combination of a device fabricated with the third semiconductor layer and a device fabricated with the fourth semiconductor layer can be manufactured in a region that is to be cut out as one semiconductor chip. Further, since thicknesses of the third and fourth semiconductor layers can be adjusted according to the devices to be manufactured, it is possible to freely set thicknesses of the first and second semiconductor layers.
(Aspect 2) The surface of the third semiconductor layer and the surface of the fourth semiconductor layer may be on a substantially same plane with each other. This makes it possible to more easily apply various semiconductor processes such as photolithography to the semiconductor substrate.
(Aspect 3) The first semiconductor layer and the second semiconductor layer may be made of the same material. A plane direction of the surface of the first semiconductor layer and a plane direction of the surface of the second semiconductor layer may be different from each other. This allows semiconductor single-crystals made of the same material with different plane directions to be exposed at desired regions, respectively, of the semiconductor substrate. By having different plane directions, the semiconductor single-crystals may differ in semiconductor manufacturing process characteristic (such as crystal growth rate and etching rate), device characteristic (such as carrier mobility), and the like from each other, although they are made of the same material. This makes it possible to manufacture, on the same semiconductor substrate, a combination of a plurality of devices manufactured by different semiconductor manufacturing processes or a plurality of devices having different characteristics.
(Aspect 4) The first semiconductor layer and the second semiconductor layer may each be made of a SiC single-crystal. The plane direction of the surface of the first semiconductor layer may be one of a silicon plane and a carbon plane, and the plane direction of the surface of the second semiconductor layer may be the other of the silicon plane and the carbon plane. This allows the silicon and carbon planes of the SiC single-crystals to be exposed at desired regions, respectively, of the semiconductor substrate. The silicon plane and the carbon plane differ in semiconductor manufacturing process characteristic and device characteristic from each other. Therefore, this makes it possible to manufacture, on the same semiconductor substrate, a combination of a plurality of devices having different characteristics.
(Aspect 5) A method for manufacturing a semiconductor substrate includes a step of placing a single-crystal, first semiconductor layer on a surface of a supporting substrate. Further, the method also includes a step of placing a single-crystal, second semiconductor layer on a surface of the first semiconductor layer. Further, the method also includes a step of selectively removing parts of the second semiconductor layer so as to cause the surface of the first semiconductor layer to be exposed. Further, the method also includes a first crystal growing step of causing a third semiconductor layer made of the same material as the first semiconductor layer to be epitaxially grown on the surface of the first semiconductor layer. This allows a surface of the third semiconductor layer to be exposed at regions from which the second semiconductor layer has been removed. This makes it possible, for example, to manufacture, in a region that is to be cut out as one semiconductor chip, a combination of a device fabricated with the second semiconductor layer and a device fabricated with the third insulating layer.
(Aspect 6) The first semiconductor layer and the second semiconductor layer may be made of the same material. A plane direction of the surface of the first semiconductor layer and a plane direction of a surface of the second semiconductor layer may be different from each other. The first crystal growing step may further cause a fourth semiconductor layer made of the same material as the second semiconductor layer to be epitaxially grown on the surface of the second semiconductor layer. With this, the first crystal growing step allows the third semiconductor layer and the fourth semiconductor layer to be epitaxially grown at the same time. With this, layers having different plane directions can be grown in one step at the same time. This makes it possible to reduce the number of steps, as compared with a case where the third semiconductor layer and the fourth semiconductor layer are grown in separate steps.
(Aspect 7) The method may further include a step of, after the first crystal growing step, causing a surface of the third semiconductor layer and a surface of the fourth semiconductor layer to be on a substantially same plane with each other. This makes it possible to more easily apply various semiconductor processes to the semiconductor substrate.
(Aspect 8) The first semiconductor layer and the second semiconductor layer may each be made of a SiC single-crystal. The plane direction of the surface of the first semiconductor layer may be one of a silicon plane and a carbon plane, and the plane direction of the surface of the second semiconductor layer may be the other of the silicon plane and the carbon plane. This allows the silicon and carbon planes of the SiC single-crystals to be exposed at desired regions, respectively, of the semiconductor substrate. The silicon plane and the carbon plane differ in device characteristic from each other. This makes it possible to manufacture, on the same semiconductor substrate, a combination of a plurality of devices having different characteristics.

### <First Embodiment>

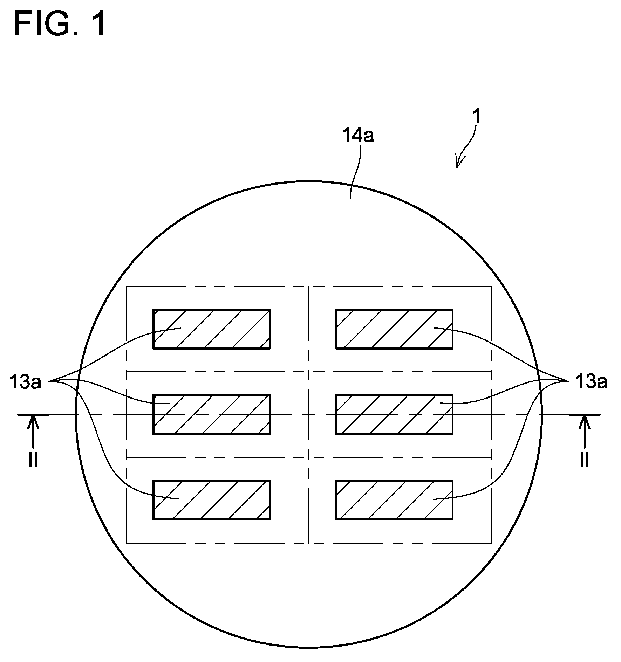

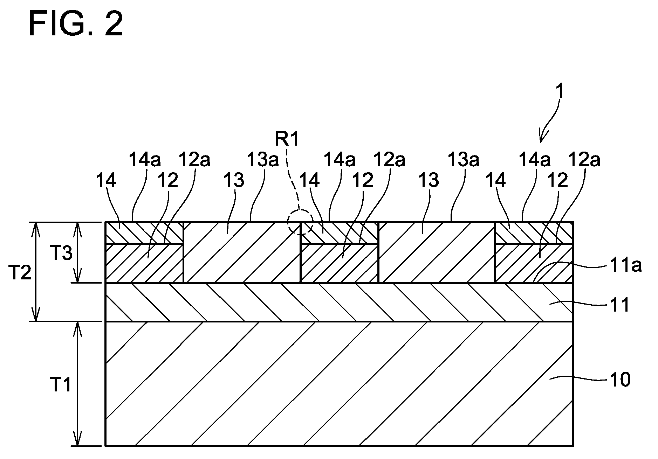

An example of a semiconductor substrate 1 that is formed by a method for manufacturing a semiconductor substrate according to a first embodiment is described with reference to the schematic views of FIGS. 1 and 2. FIG. 1 is a top view of the semiconductor substrate 1. FIG. 2 is a cross-sectional view of the semiconductor substrate 1 as taken along the line II-II in FIG. 1. In FIG. 1, each of the rectangular regions surrounded by dotted lines represents a die region that is to be cut out as one semiconductor chip. Exposed at a surface of the semiconductor substrate 1 are a surface 13a of a third semiconductor layer 13 and a surface 14a of a fourth semiconductor layer 14. In FIG. 1, the surface 13a of the third semiconductor layer 13 is hatched. The surface 13a of the third semiconductor layer 13 is disposed in a predetermined place in each of the die regions.

As shown in FIG. 2, the semiconductor substrate 1 includes: a supporting substrate 10; a first semiconductor layer 11 disposed on a surface of the supporting substrate 10; a second semiconductor layer 12 disposed on parts of a surface of the first semiconductor layer; the third semiconductor layer 13, which is disposed on those parts of the surface of the first semiconductor layer 11 on which the second semiconductor layer 12 is not disposed; and the fourth semiconductor layer 14, which is disposed on a surface of the second semiconductor layer 12. The surface 13a of the third semiconductor layer 13 and the surface 14a of the fourth semiconductor layer 14 are on a substantially same plane with each other.

The supporting substrate 10 is a substrate for reinforcing the first to fourth semiconductor layers 11 to 14 and a substrate that is not required to have high crystallinity. The supporting substrate 10 may be made of polycrystalline SiC such as a 6H polytype or a 4H polytype. Alternatively, the supporting substrate 10 may be a sintered body made of a mixture of ceramic materials. The supporting material may be made of at least one of various ceramic materials such as SiC, Si, AlN, Al2O3, GaN, SiN, SiO2, and TaO. Alternatively, the supporting substrate 10 maybe a sapphire substrate.

The first semiconductor layer 11 and the second semiconductor layer 12 are each made of a 4H-SiC single-crystal. A plane direction of a surface 11a of the first semiconductor layer 11 is a (0001) plane called a silicon plane. A plane direction of a surface 12a of the second semiconductor layer 12 is a (000-1) plane called a carbon plane.

The third semiconductor layer 13 is made of a 4H-SiC single-crystal, which is the same as the material of which the first semiconductor layer 11 is made. The third semiconductor layer 13 has a crystal orientation aligned with that of the first semiconductor layer 11. Therefore, the surface 13a of the third semiconductor layer 13 is a silicon plane. The fourth semiconductor layer 14 is made of a 4H-SiC single-crystal, which is the same as the material of which the second semiconductor layer 12 is made. The fourth semiconductor layer 14 has a crystal orientation aligned with that of the second semiconductor layer 12. Therefore, the surface 14a of the fourth semiconductor layer 14 is a carbon plane.

A height of the surface 13a of the third semiconductor layer 13 from the supporting substrate 10 is equal to or greater than a height of the surface 12a of the second semiconductor layer 12 from the supporting substrate 10. A height of the surface 14a of the fourth semiconductor layer 14 from the supporting substrate 10 is equal to the height of the surface 13a of the third semiconductor layer 13 from the supporting substrate 10.

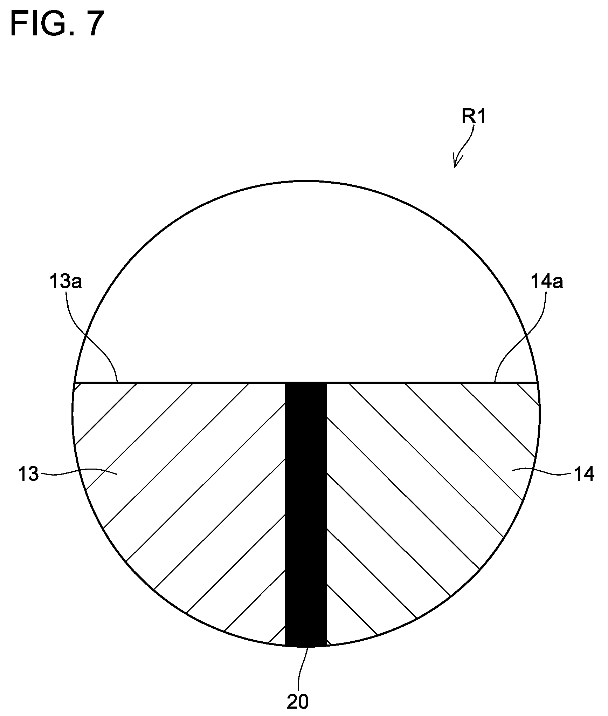

FIG. 7 shows a partially-enlarged view of a region R1 including an interface between the third semiconductor layer 13 and the fourth semiconductor layer 14. Provided at the interface between the third semiconductor layer 13 and the fourth semiconductor layer 14 is an intermediate layer 20, which is either a layer having many crystal defects and low crystallinity or an amorphous layer.

The semiconductor substrate 1 is thick and strong enough to be handled by a common semiconductor manufacturing apparatus. As such, the semiconductor substrate 1 can be subjected to known various semiconductor processes such as photolithography and etching, so that various devices can be formed on the surfaces of the third and fourth semiconductor layers 13 and 14. A diameter of the semiconductor substrate 1 may fall within a range of 50 mm to 300 mm. A thickness T1 of the supporting substrate 10 needs only be set so that the supporting substrate 10 can be mechanically strong enough to withstand semiconductor manufacturing processes. The thickness T1 may fall within a range of 50 µm to 1000 µm, for example. A thickness of each of the first and second semiconductor layers 11 and 12 may fall within a range of 0.3 to 1.0 µm, for example. A total thickness T2 of the first and third semiconductor layers 11 and 13 and a total thickness T3 of the second and fourth semiconductor layers 12 and 14 may be set as appropriate according to the devices to be manufactured. For example, in the case of manufacture of horizontal devices forming elements such as transistors in a direction parallel to the surface of the semiconductor substrate 1, the total thicknesses T2 and T3 may each be 5 µm or more. Alternatively, in the case of manufacture of vertical devices forming elements in a direction perpendicular to the surface of the semiconductor substrate 1, the total thicknesses T2 and T3 may each be several tens of micrometers.

### <Process for Manufacturing Semiconductor Substrate 1>

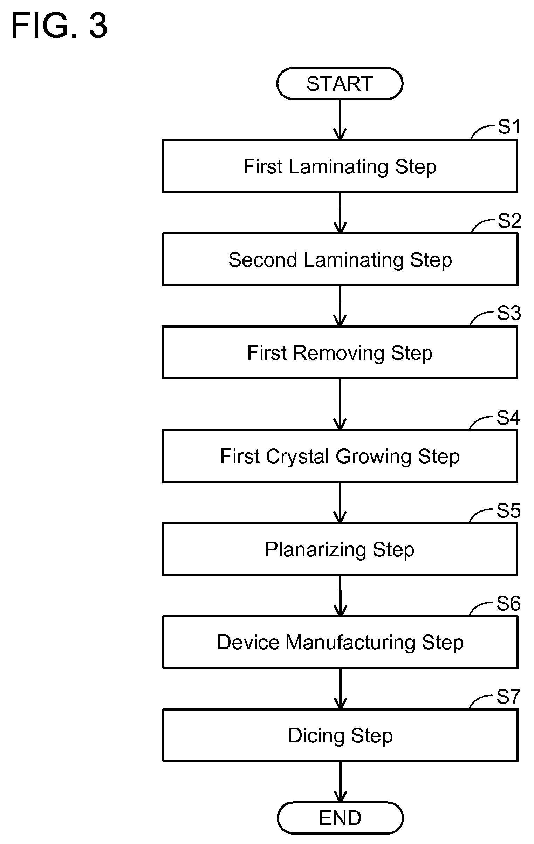

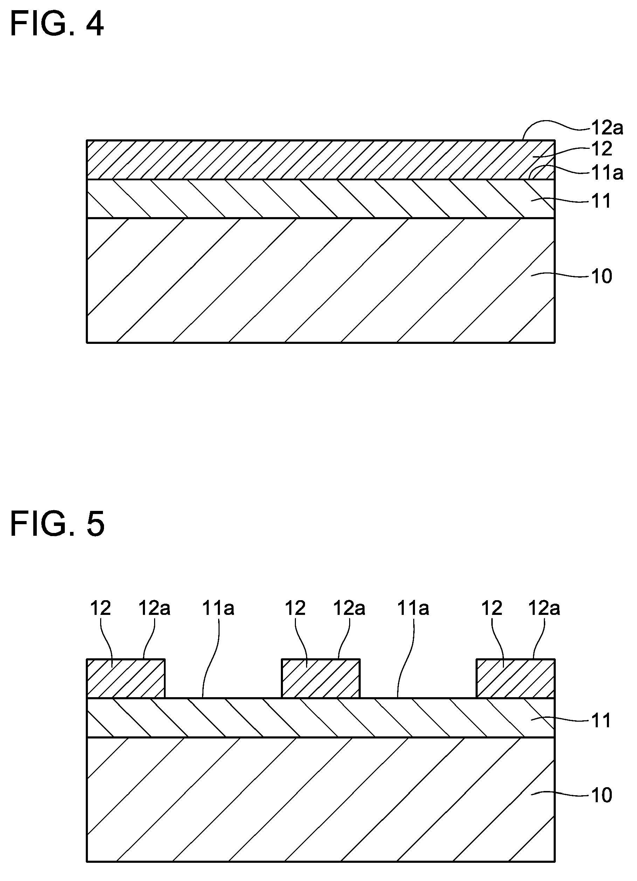

Steps of a process for manufacturing a semiconductor substrate 1 are described with reference to the flow chart of FIG. 3 and the schematic views of FIGS. 4 to 6. Step S1 is a first laminating step. In the first laminating step, the first semiconductor layer 11 made of a 4H-SiC single-crystal is laminated on the surface of the supporting substrate 10. The surface 11 a of the first semiconductor layer 11 is a silicon plane.

The first laminating step is described by taking, as an example, a case where room-temperature bonding is carried out. The first semiconductor layer 11 and the supporting substrate 10 are set into a chamber of a room-temperature bonding apparatus (not illustrated). The chamber is evacuated, and then a back surface of the first semiconductor layer 11 and the surface of the supporting substrate 10 are irradiated with ion beams. This allows the surfaces to be activated by removing the oxidized films and the adsorbed layers from the material surfaces and thereby exposing the bonding hands. After that, the back surface of the first semiconductor layer 11 and the surface of the supporting substrate 10 are brought into contact with each other, whereby the first semiconductor layer 11 the supporting substrate 10 can be bonded to each other. The bonding pressure may fall within a range 10 to 50 MPa.

Step S2 is a second laminating step. In the second laminating step, the second semiconductor layer 12 made of a 4H-SiC single-crystal is laminated on the surface 11a of the first semiconductor layer 11. The surface 12a of the second semiconductor layer 12 is a carbon plane. The second laminating step is not described here, as the second laminating step is identical in content to the first laminating step described above. Thus formed is a structure shown in the schematic view of FIG. 4 in which the supporting substrate 10, the first semiconductor layer 11, and the second semiconductor layer 12 are stacked in this order.

Step S3 is a first removing step. In the first removing step, parts of the second semiconductor layer 12 are selectively removed so that the surface 11a of the first semiconductor layer 11 becomes exposed. The first removing step may be carried out by using a photolithography technique and an etching technique that are commonly used in semiconductor manufacturing processes. Thus formed is a structure shown in the schematic view of FIG. 5.

Step S4 is a first crystal growing step. The first crystal growing step is a step in which the third semiconductor layer 13 made of a 4H-SiC single-crystal is homoepitaxially grown on the surface 11a of the first semiconductor layer 11 and the fourth semiconductor layer 14 made of a 4H-SiC single-crystal is homoepitaxially grown on the surface 12a of the second semiconductor layer 12. The first crystal growing step is described by taking, as an example, a case where a thermal CVD method is employed. The semiconductor substrate shown in FIG. 5 is set into a chamber (not illustrated). The semiconductor substrate is heated, and a silane (SiH4) gas and a propane (C3H8) gas serving as raw material gases are supplied into the chamber. Epitaxial growth allows a single-crystal thin film to be grown on a foundation single-crystal substrate with their crystal orientations aligned with each other. Therefore, the surface 13a of the third semiconductor layer 13, which has grown on the first semiconductor layer 11 a, becomes a silicon plane. Further, the surface 14a of the fourth semiconductor layer 14, which has grown on the second semiconductor layer 12, becomes a carbon plane.

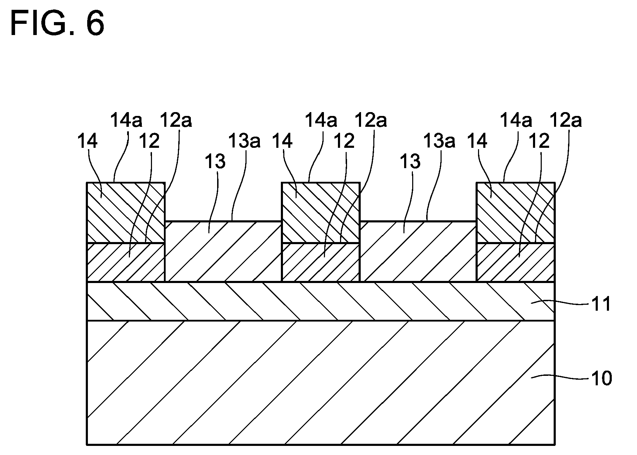

The first crystal growing step forms a structure shown in the schematic view of FIG. 6. In the first crystal growing step, homoepitaxial growth may be carried out so that the height of the surface 13a of the third semiconductor layer 13 from the supporting substrate 10 becomes equal to or greater than the height of the surface 12a of the second semiconductor layer 12 from the supporting substrate 10. This makes it possible to prevent the surface 12a of the second semiconductor layer 12 from being exposed due to the disappearance of the fourth semiconductor layer 14 in planarizing the surface of the semiconductor substrate by etching back or polishing the fourth semiconductor layer 14 in the subsequent planarizing step.

In the first crystal growing step, the third semiconductor layer 13 and the fourth semiconductor layer 14 are homoepitaxially grown at the same time. Since the third semiconductor layer 13 and the fourth semiconductor layer 14 have different crystal orientations, the crystal orientations are not stable at the interface between the two layers. Therefore, as shown in FIG. 7, the intermediate layer 20, which has low crystallinity, is formed at the interface between the third semiconductor layer 13 and the fourth semiconductor layer 14. The intermediate layer 20 allows the third semiconductor layer 13 and the fourth semiconductor layer 14 to be in a continuous state without having a defined interface.

Step S5 is the planarizing step. In the planarizing step, the fourth semiconductor layer 14 is subjected to etch back based on dry etching or the like, polishing, or the like so that the surface 13a of the third semiconductor layer 13 and the surface 14a of the fourth semiconductor layer 14 become to be on a substantially same plane with each other. In the planarizing step, for example, a CMP (Chemical Mechanical Polishing) method may be employed. This makes it possible to manufacture the semiconductor substrate 1 shown in FIGS. 1 and 2.

Step S6 is a device manufacturing step that is carried out with the semiconductor substrate 1 shown in FIGS. 1 and 2. In the device manufacturing step, known various semiconductor processes can be applied to the semiconductor substrate 1.

Step S7 is a dicing step. In the dicing step, the die regions shown in FIG. 1 are cut out by a dicing saw into semiconductor chips. Thus, the flow ends.

### <Effects>

In the semiconductor substrate 1 shown in FIGS. 1 and 2, the surface 13a (silicon plane) of the third semiconductor layer 13 and the surface 14a (carbon plane) of the fourth semiconductor layer 14 can be exposed at desired regions, respectively, of the semiconductor substrate 1. With this, carrying out the device manufacturing step (step S6) makes it possible to form, in each one of the die regions, a combination of a device fabricated with the third semiconductor layer 13 and a device fabricated with the fourth semiconductor layer 14. The silicon plane and the carbon plane differ in semiconductor manufacturing process characteristic (such as crystal growth rate and etching rate), device characteristic (such as carrier mobility), and the like from each other, although they are made of the same 4H-SiC single-crystal. Therefore, this makes it possible to manufacture, on one semiconductor chip, a combination of devices having different device characteristics. Thereby, this makes it possible to eliminate the need for post-processing steps of fabricating, as separate semiconductor chips, a device fabricated with a 4H-SiC single-crystal substrate whose surface is a silicon plane and a device fabricated with a 4H-SiC single-crystal substrate whose surface is a carbon plane and mounting these semiconductor chips into one package. This in turn makes it possible to achieve simpler device structures and lower manufacturing costs.

By manufacturing, on one semiconductor substrate 1, a device fabricated with the third semiconductor layer 13 and a device fabricated with the fourth semiconductor layer 14, a wire through which the devices are connected to each other can be fabricated by the device manufacturing step (step S6). Therefore this makes it possible to eliminate the need to a post-processing step of wire bonding between a semiconductor chip fabricated with the third semiconductor layer 13 and a semiconductor chip fabricated with the fourth semiconductor layer 14.

By growing the third semiconductor layer 13 on the surface of the first semiconductor layer 11 and growing the fourth semiconductor layer 14 on the surface of the second semiconductor layer 12,
the heights of the surface 13a of the third semiconductor layer 13 and the surface 14a of the fourth semiconductor layer 14 relative to each other can be adjusted. With this, adjustment of the thicknesses of semiconductor layers according to the devices to be manufactured can be made by the third semiconductor layer 13 and the fourth semiconductor layer 14. This makes it possible to freely set the thicknesses of the first and second semiconductor layers 11 and 12.

The planarizing step (step S5) allows the surface 13a of the third semiconductor layer 13 and the surface 14a of the fourth semiconductor layer 14 to be on a substantially same plane with each other. Thereby, this makes it possible to more easily apply various semiconductor processes such as photolithography to the semiconductor substrate 1.

The first crystal growing step (step S4) allows the third semiconductor layer 13 and the fourth semiconductor layer 14 to be epitaxially grown at the same time. With this, layers having different plane directions can be grown in one step at the same time. This makes it possible to reduce the number of steps, as compared with a case where the third semiconductor layer 13 and the fourth semiconductor layer 14 are grown in separate steps.

An embodiment of the present invention has been described in detail with reference to the drawings, however, this is a mere exemplary indication and thus does not limit the scope of the claims. The art described in the claims includes modifications and variations of the specific examples presented above.

### <Modifications>

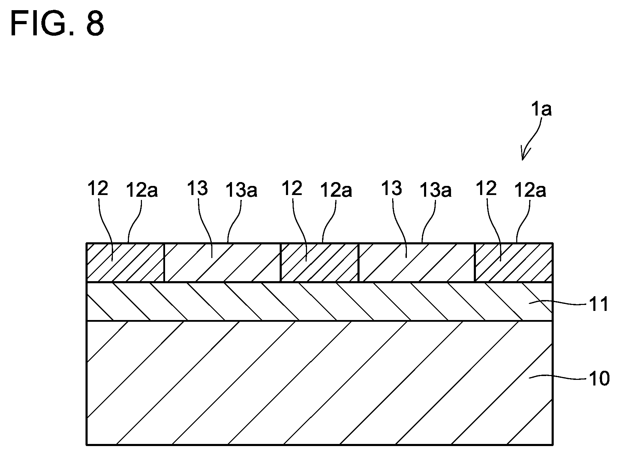

In the structure shown in the schematic view of FIG. 6, the height of the surface 13a of the third semiconductor layer 13 from the supporting substrate 10 may be lower than the height of the surface 12a of the second semiconductor layer 12 from the supporting substrate 10. With this, in the planarizing step (step S5), the fourth semiconductor layer 14 is removed so that the surface 12a of the second semiconductor layer 12 becomes exposed, and the fourth semiconductor layer 14 and the third semiconductor layer 13 are etched back so that the surface 12a of the second semiconductor layer 12 and the surface 13a of the third semiconductor layer 13 become to be on a substantially same plane with each other. In this planarizing step, a CMP method may be employed. Thereby, this makes it possible to manufacture a semiconductor substrate 1a shown in FIG. 8. The surface 12a of the second semiconductor layer 12 and the surface 13a of the third semiconductor layer 13 are exposed at a surface of the semiconductor substrate 1a.

The polytype of SiC crystal is not limited to 4H. Another polytype such as 3C-SiC or 6H-SiC may alternatively be used. In the case of use of 3C-SiC, a (111) plane may be used as a silicon plane, and a (-1-1-1) plane may be used as a carbon plane. Further, in the case of use of 3C-SiC, a (001) plane may be used as one of the different plane directions.

Various combinations of the first semiconductor layer 11 and the second semiconductor layer 12 are possible. For example, a combination of SiC single-crystals of the same polytype with plural types of plane directions differing from those of a silicon plane and a carbon plane is possible. A combination of SiC single-crystals of different polytypes is also possible. A combination of Si single-crystals having different plane directions is also possible. Alternatively, compound semiconductors may be used.

The present invention is not limited to the embodiment in which two layers, namely the first semiconductor layer 11 and the second semiconductor layer 12, are laminated. Three or more semiconductor layers may be laminated. An increase in the number of semiconductor layers that are laminated enables an increase in the number of types of semiconductor layers to be exposed at the surface of the semiconductor substrate.

The semiconductor substrate disclosed herein is applicable to applications other than semiconductor devices. For example, the semiconductor substrate may be applied to MEMS (Micro Electro Mechanical Systems). Since Si single-crystals vary in etching shape according to plane directions, more complicated shapes can be formed by placing, on the surface of the semiconductor substrate, Si single-crystals having plural types of plane directions.

Without being limited to room-temperature bonding, the step of laminating the first semiconductor layer 11 and the second semiconductor layer 12 may be carried out by any of various methods. For example, a bonding technique such as plasma bonding, OH-OH bonding, or adhesive bonding may be employed. Alternatively, the first semiconductor layer 11 and the second semiconductor layer 12, which have been turned into thin films, may be laminated by using an exfoliation technique based on hydrogen atom ablation. In this exfoliation technique, a high-concentration hydrogen layer is formed by implanting hydrogen ions through a principal surface of a SiC crystal substrate, and then the principal surface is attached to the supporting substrate 10. After that, a SiC crystal thin film is exfoliated from the SiC crystal substrate with the high-concentration hydrogen layer.

A semiconductor substrate having the same structure as a so-called SOI (Silicon on Insulator) may be formed by forming an insulating layer between the supporting substrate 10 and the first semiconductor layer 11 or between the first semiconductor layer 11 and the second semiconductor layer 12.

In the case described above, CMP is employed to carry out polishing processing in the removing step. However, the present invention is not limited to this embodiment. As polishing processing, mechanical polishing, chemical polishing, or the like may be employed. Mechanical polishing is a polishing method that involves the use of a polishing pad carrying abrasive grains of diamond or the like. Chemical polishing is a method that involves the use of a chemical that removes asperities on the surface of the supporting substrate.

Technical features described in the description and the drawings may technically be useful alone or in various combinations, and are not limited to the combinations as originally claimed. Further, the art described in the description and the drawings may concurrently achieve a plurality of aims, and technical significance thereof resides in achieving any one of such aims.

## Claims

1. A semiconductor substrate comprising:
a supporting substrate;
a single-crystal, first semiconductor layer disposed on a surface of the supporting substrate;
a single-crystal, second semiconductor layer disposed on parts of a surface of the first semiconductor layer; and
a single-crystal, third semiconductor layer disposed on those parts of the surface of the first semiconductor layer on which the second semiconductor layer is not disposed,
wherein the third semiconductor layer has a crystal orientation aligned with that of the first semiconductor layer and is made of the same material as the first semiconductor layer.

2. The semiconductor substrate of claim 1, further comprising a single-crystal, fourth semiconductor layer disposed on a surface of the second semiconductor layer,
wherein the fourth semiconductor layer has a crystal orientation aligned with that of the second semiconductor layer and is made of the same material as the second semiconductor layer, and
an interface between the third semiconductor layer and the fourth semiconductor layer is in an amorphous state.

3. The semiconductor substrate of claim 2, wherein a surface of the third semiconductor layer and a surface of the fourth semiconductor layer are on a substantially same plane with each other.

4. The semiconductor substrate of any one of claims 1 to 3, wherein the first semiconductor layer and the second semiconductor layer are made of the same material, and
a plane direction of the surface of the first semiconductor layer and a plane direction of a surface of the second semiconductor layer are different from each other.

5. The semiconductor substrate of claim 4, wherein the first semiconductor layer and the second semiconductor layer are each made of a SiC single-crystal,
the plane direction of the surface of the first semiconductor layer is one of a silicon plane and a carbon plane, and
the plane direction of the surface of the second semiconductor layer is the other of the silicon plane and the carbon plane.

6. A method for manufacturing a semiconductor substrate, comprising:
a step of placing a single-crystal, first semiconductor layer on a surface of a supporting substrate;
a step of placing a single-crystal, second semiconductor layer on a surface of the first semiconductor layer;
a step of selectively removing parts of the second semiconductor layer so as to cause the surface of the first semiconductor layer to be exposed; and
a first crystal growing step of causing a third semiconductor layer made of the same material as the first semiconductor layer to be epitaxially grown on the surface of the first semiconductor layer.

7. The method of claim 6, wherein the first semiconductor layer and the second semiconductor layer are made of the same material,
a plane direction of the surface of the first semiconductor layer and a plane direction of a surface of the second semiconductor layer are different from each other, and
the first crystal growing step further causes a fourth semiconductor layer made of the same material as the second semiconductor layer to be epitaxially grown on the surface of the second semiconductor layer.

8. The method of claim 7, further comprising a step of, after the first crystal growing step, causing a surface of the third semiconductor layer and a surface of the fourth semiconductor layer to be on a substantially same plane with each other.

9. The method of claim 7 or 8, wherein the first semiconductor layer and the second semiconductor layer are each made of a SiC single-crystal,
the plane direction of the surface of the first semiconductor layer is one of a silicon plane and a carbon plane, and
the plane direction of the surface of the second semiconductor layer is the other of the silicon plane and the carbon plane.
